# DEMANDE DE BREVET EUROPEEN

(11) **EP 0 930 650 A1**
(43) Date de publication de la demande: **21.07.1999**
(21) Numéro de dépôt: 99420012.9
(22) Date de dépôt: 18.01.1999
(51) Int. Cl.: H01L 23/427

(54) **Echangeur di-phasique ou monophasique pour au moins un composant électronique de puissance**

(30) Priorité: 19.01.1998 FR 9800744
(71) Demandeur: Ferraz Date Industries, 38350 La Mure (FR)
(72) Inventeur: Julien, Jean-Noel, 38350 La Mure (FR); Lachise, Jacques, 69120 Vaulx en Velin (FR)
(74) Mandataire: Myon, Gérard Jean-Pierre

(57) **Abrégé**

Echangeur de chaleur di-phasique ou monophasique (1) pour au moins un composant électronique de puissance (3), ledit échangeur comprenant une unité (2) d'échange thermique avec ledit composant et plusieurs tubes (5) d'échange avec un fluide caloporteur, lesdits tubes étant raccordés à ladite unité d'échange thermique formée d'au moins une plaque (4) rigide pourvue de zones (7) de réception de parties desdits tubes caractérisé en ce que ladite unité d'échange thermique est pourvue, au niveau de deux bords (4c, 4d) de moyens (4e, 4f, 4g, 4h, 8) d'assemblage bord à bord avec une plaque analogue (4', 4") appartenant à un échangeur voisin (1', 1") dans un groupe d'échangeurs de chaleur, lesdites plaques assemblées étant globalement coplanaires.

## Description

L'invention a trait à un échangeur de chaleur di-phasique ou monophasique pour composants électroniques de puissance.

Des échangeurs de chaleur de ce type sont nécessaires pour éviter un échauffement dommageable de composants électroniques de puissance tels que des circuits IGBT (Insulated Gate Bipolar Transistor) ou équivalents. Un échangeur de chaleur comprenant plusieurs tubes d'évaporation/condensation d'un liquide caloporteur et un bloc formant unité d'échange thermique avec un composant électronique est décrit dans la demande de brevet européen 0 417 299. Par ailleurs, WO-A-95/17 765 divulgue un échangeur de chaleur essentiellement constitué d'une plaque pourvue de gorges de réception de tubes de circulation d'un liquide caloporteur.

Les échangeurs de chaleur de ce type sont généralement installés en batterie pour refroidir un nombre conséquent de composants électroniques de dimensions variées. Dans ce cas, avec le dispositif connu, il est nécessaire de prévoir un châssis supportant les échangeurs de chaleur en batterie, ce qui majore sensiblement le prix de revient d'une installation. En outre, dans les dispositifs connus, les unités d'échange thermique doivent être configurées en fonction de la taille et de l'emplacement du ou des composants qu'elles doivent supporter. Ceci induit la création d'un grand nombre de références d'unités d'échange thermique, ce qui rend plus complexe la fabrication et la maintenance des groupes d'échangeurs de chaleur.

C'est à ces inconvénients qu'entend plus particulièrement remédier l'invention en proposant un échangeur de chaleur qui peut participer à une structure modulaire sans utilisation d'un châssis. L'invention vise également à proposer un échangeur de chaleur adaptable à différents types de composants.

Dans cet esprit, l'invention concerne un échangeur de chaleur di-phasique ou monophasique pour au moins un composant électronique de puissance, ledit échangeur comprenant une unité d'échange thermique avec ledit composant et plusieurs tubes d'échange avec un fluide caloporteur, lesdits tubes étant raccordés à ladite unité d'échange thermique qui est formée d'au moins une plaque rigide pourvue de zones de réception de certaines parties desdits tubes caractérisé et en ce que ladite unité d'échange thermique est pourvue, au niveau de bords parallèles de la ou des plaques, de moyens d'assemblage bord à bord avec une plaque analogue appartenant à un échangeur voisin dans un groupe d'échangeurs thermiques, les plaques assemblées étant globalement coplanaires.

Grâce à l'invention, la plaque rigide de l'unité d'échange thermique forme une structure autoporteuse pour l'échangeur de chaleur, ce qui permet de se dispenser de l'utilisation systématique d'un châssis.

Selon une première variante de réalisation de l'invention, la plaque porte, sur un premier bord, une première feuillure et, sur un second bord sensiblement parallèle audit premier bord, une seconde feuillure, lesdites première et seconde feuillures étant disposées en opposition, une bordure d'une feuillure s'étendant dans l'alignement d'une première face principale de ladite plaque alors qu'une bordure de l'autre feuillure s'étend dans l'alignement d'une seconde face principale de ladite plaque.

Selon une autre variante de réalisation de l'invention, l'unité d'échange thermique est formée de deux plaques accolées pourvues de gorges disposées en regard et définissant des zones de réception des parties des tubes formant évaporateur, ces plaques étant en débordement l'une par rapport à l'autre sur deux bords opposés et sensiblement parallèles de l'unité d'échange thermique. Dans ce cas, on peut prévoir que les parties des plaques qui débordent de la plaque en regard forment les bordures de deux feuillures disposées en opposition sur les bords de cette unité.

Selon un autre aspect avantageux de l'invention, applicable quel que soit le mode de réalisation considéré, l'échangeur comprend des moyens de blocage d'une première feuillure d'une première unité appartenant à un premier échangeur en position emboîtée par rapport à une seconde feuillure d'une seconde unité appartenant à un second échangeur. Cet aspect de l'invention permet de créer une structure autoporteuse pour un assemblage de plusieurs échangeurs de chaleur disposés côte à côte.

Dans ce cas, l'on peut prévoir qu'une bordure d'une feuillure comprend des orifices de passage de la tige de vis de blocage et qu'une bordure de l'autre feuillure comprend des taraudages de réception de l'extrémité filetée de ces vis.

Selon un autre aspect avantageux de l'invention, la plaque porte, sur l'une au moins de ses faces principales, des moyens de fixation de composants électroniques de puissance de formes variées et en nombre variable. Cet aspect de l'invention permet, à l'aide d'un seul type de plaques, d'accommoder plusieurs types de composants électroniques, ce qui permet de diminuer sensiblement le nombre de référence de plaques susceptibles d'appartenir à des unités d'échange thermique par rapport aux dispositifs de l'art antérieur. On peut notamment prévoir que ces moyens de fixation sont des taraudages répartis sur l'une au moins des faces principales de la ou des plaques.

L'invention sera mieux comprise et d'autres avantages de celle-ci apparaîtront plus clairement à la lumière de la description qui va suivre de trois modes de réalisation d'un échangeur de chaleur di-phasique conforme à son principe, donnée uniquement à titre d'exemple et faite en référence aux dessins annexés dans lesquels :
- La figure 1 est une vue en perspective d'un échangeur de chaleur conforme à l'invention dans un assemblage de plusieurs échangeurs ;
- la figure 2 est une coupe selon la ligne II-II à la figure 1 ;
- la figure 3 est une vue en élévation d'une plaque appartenant à un échangeur de la figure 1 sur laquelle est monté un composant électronique ;
- les figures 4 à 7 sont, à plus petite échelle, des vues analogues à la figure 3 sur lesquelles sont montés d'autres composants électroniques de puissance ;
- la figure 8 est une vue analogue à la figure 2 pour un échangeur de chaleur conforme à un second mode de réalisation de l'invention et
- la figure 9 est une vue en perspective d'un ensemble réalisé avec des échangeurs de chaleur conformes à un troisième mode de réalisation de l'invention.

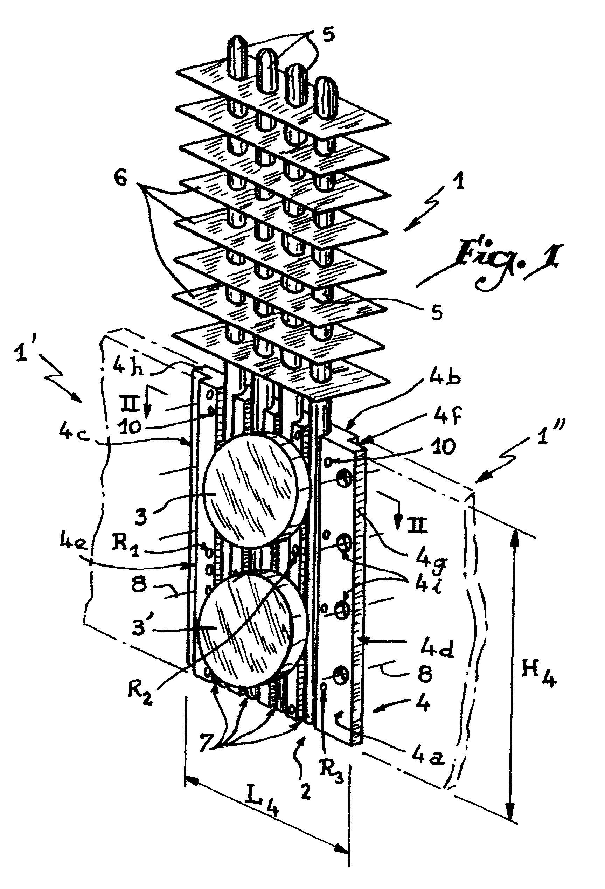

Trois échangeurs de chaleur identiques 1, 1' et 1" sont représentés à la figure 1, les échangeurs 1' et 1" étant simplement silhouettés en traits mixtes. L'échangeur de chaleur 1 comprend une unité 2 destinée à recevoir deux composants électroniques 3 et 3' tels que des circuits IGBT ou équivalents. L'unité 2 est essentiellement composée d'une plaque 4 en aluminium sur laquelle sont raccordés des tubes 5 d'évaporation et de condensation d'un liquide caloporteur tel que du méthanol ou de l'eau. Dans la partie qui dépasse de l'unité 2, les tubes 5 sont pourvus d'ailettes de refroidissement 6 qui permettent de dissiper la chaleur.

Le principe de fonctionnement est le suivant : La chaleur dégagée par les composants 3 et 3' a pour effet d'augmenter la température de l'unité 2, ce qui conduit à une évaporation du liquide se trouvant dans la partie inférieure des tubes 5 à l'intérieur de gorges parallèles 7 de réception de cette partie inférieure des tubes. La vapeur formée dans la partie inférieure des tubes circule de bas en haut à l'intérieur de chaque tube 5. Au cours de cette circulation et du fait de la dissipation des calories à travers la paroi des tubes 5 et les ailettes 6, le fluide se refroidit et se recondense, de sorte qu'il redescend le long de parois de chaque tube 5 sous l'effet de la gravité. Il peut alors être à nouveau évaporé pour refroidir le bloc 2. On note 4a la face de la plaque 4 sur laquelle sont montés les composants 3. On note 4b la face de la plaque 4 opposée à la face 4a.

Selon une variante non représentée de l'invention, des composants électroniques pourraient également être fixés sur la face 4b de la plaque 4.

Sur les deux bords sensiblement verticaux 4c et 4d de la plaque 4 qui sont parallèles entre eux, la plaque porte deux feuillures 4e et 4f qui sont disposées en opposition.

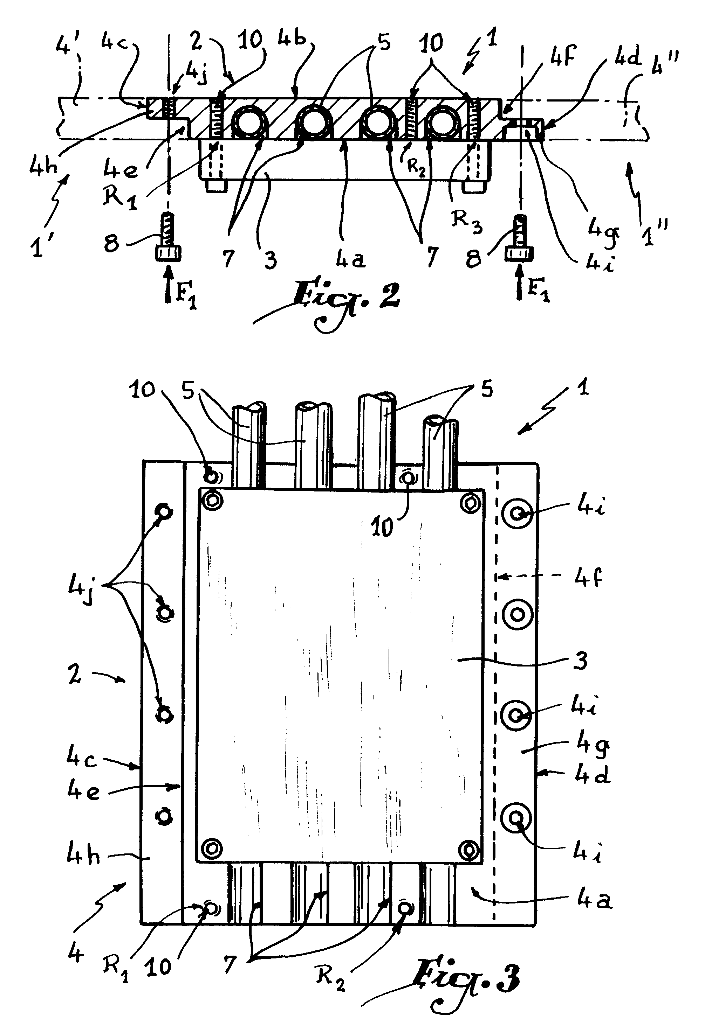

Plus précisément, la feuillure 4f comprend une bordure 4g qui prolonge la surface 4a alors que la feuillure 4e comprend une bordure 4h qui prolonge la surface 4b. Ainsi, et comme il ressort plus clairement de la figure 2, lorsque des plaques 4 ou équivalentes sont disposées côte à côte, il est possible d'emboîter la feuillure 4e d'une plaque 4 et la feuillure 4f d'une plaque 4' voisine. De la même manière, la feuillure 4f permet l'assemblage avec une feuillure analogue à la feuillure 4e et appartenant à une plaque 4" voisine. Dans cette position, des vis de blocage 8, visibles à la figure 2, peuvent être insérées dans une série d'orifices 4i de la bordure 4g de la feuillure 4f afin que leurs extrémités filetées soient reçues dans des taraudage 4j de la bordure 4h d'une feuillure 4e disposée en emboîtement derrière la bordure 4g par rapport au sens d'introduction des vis 8, représenté par la flèche F₁ à la figure 2.

Ainsi, les feuillures 4e et 4f et les vis 8 constituent des moyens d'assemblage bord à bord rigide des plaques 4 entre elles, ce qui permet de constituer un groupe d'échangeurs de chaleur rigide sans utilisation d'un cadre ou d'un châssis. Les plaques 1, 1' et 1'' assemblées sont coplanaires, de telle sorte que les tubes 5 et leurs ailettes 6 n'interfèrent pas entre eux.

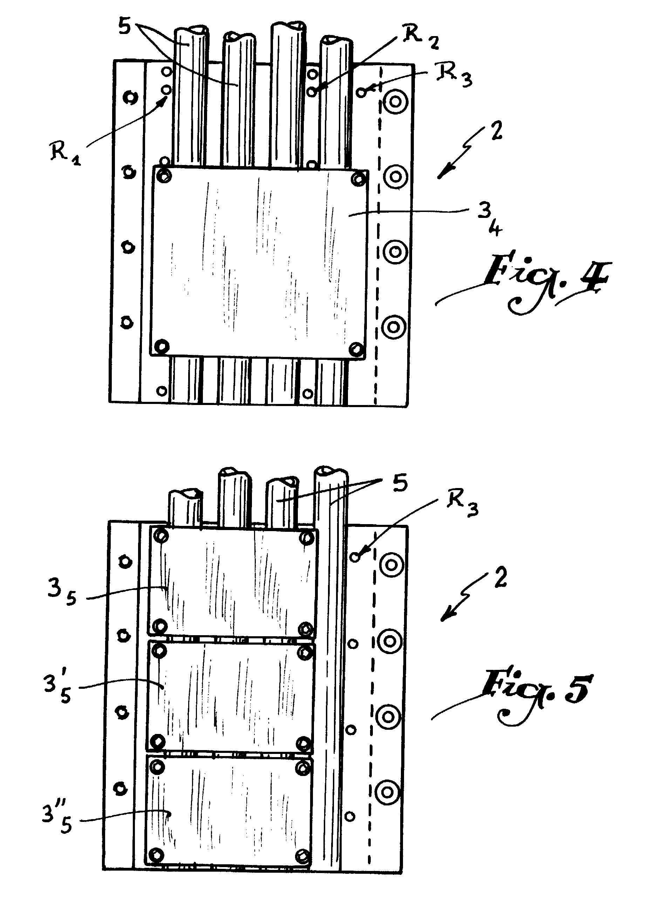

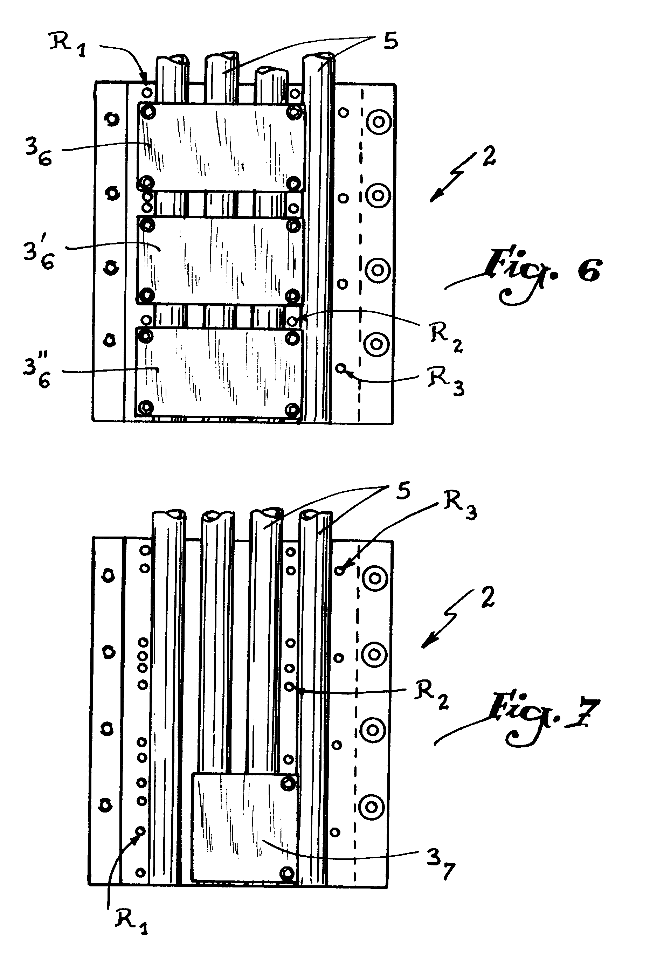

Sur sa face 4a, la plaque 4 porte trois rangées de taraudages 10, notées respectivement R₁, R₂ et R₃. Les composants 3 et 3'sont montés sur la plaque 4 en introduisant dans certains des taraudages 10 des vis de fixation. On comprend, en comparant les figures 1 et 3 à 7, que les taraudages 10 permettent d'accommoder des composants 3, 3', 3₃, 3₄, 3₅, 3'₅, 3"₅, 3₆, 3'₆, 3"₆ et 3₇ de formes et de dimensions variées. Ainsi, lorsque la largeur L₄ et la hauteur H₄ de la plaque 4 sont déterminées en fonction de l'encombrement de l'échangeur, on peut utiliser une unique plaque pour recevoir pratiquement tout type de composants, étant entendu que les composants sont normalisés quant à l'emplacement des vis de fixation qui les supportent.

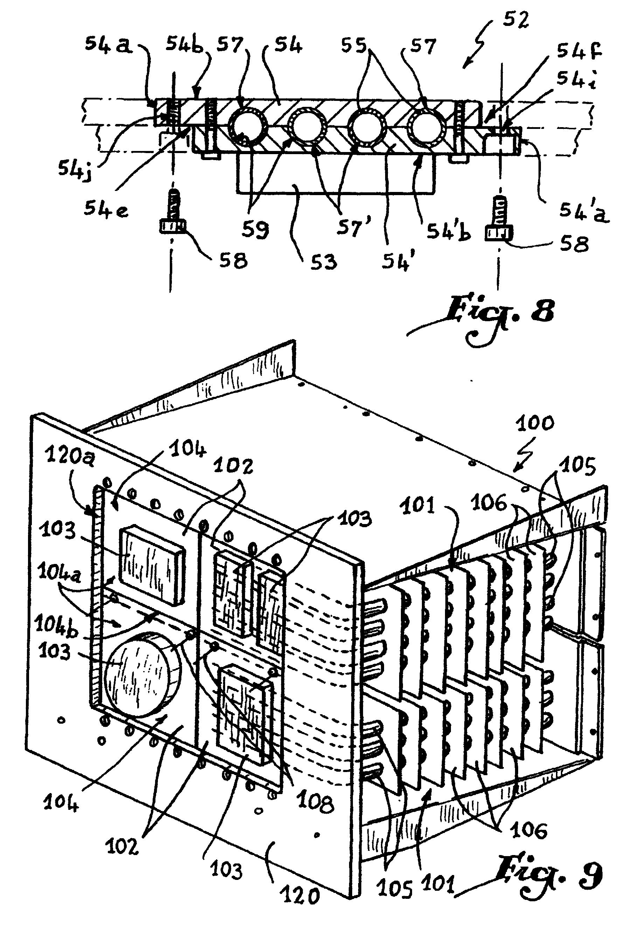

Dans le second mode de réalisation de l'invention représenté à la figure 8, les éléments analogues à ceux du mode de réalisation des figures précédentes portent des références identiques augmentées de 50. Dans ce mode de réalisation, l'unité d'échange thermique 52 qui supporte un composant 53 est formée de deux plaques 54 et 54' pourvues sur leur face en regard de gorges longitudinales 57 et 57'. Les gorges 57 et 57' sont disposées en face les unes des autres de façon à définir des logements 59 de réception de la partie formant évaporateur des tubes 55 contenant un liquide caloporteur. Les plaques 54 et 54' sont montées en débordement l'une par rapport à l'autre, de sorte qu'un bord 54a de la plaque 54 n'est pas recouvert par la plaque 54' alors qu'un second bord 54'a de la plaque 54' n'est pas recouvert par la plaque 54. Les bords 54a et 54'a qui sont opposés et sensiblement parallèles, forment ainsi les bordures de deux feuillures 54e et 54f, disposées en opposition. Les bordures 54a et 54'a prolongent respectivement la surface externe 54b de la plaque 54 et la surface externe 54'b de la plaque 54'. Comme dans le mode de réalisation précédent, les bords 54a et 54'a sont pourvus d'orifices 54i et de perçages 54j de réception de vis de fixation 58. Ceci permet d'obtenir un assemblage bord à bord d'une unité 52 avec une unité analogue, cet assemblage étant rigide alors que les unités 52 ou analogues sont coplanaires.

Dans le mode de réalisation de la figure 9, les éléments analogues à ceux du mode de réalisation des figures 1 à 8 portent des références identiques augmentées de 100. L'ensemble 100 d'échangeurs de chaleur 101 représenté à la figure 9 comprend quatre échangeurs montés sur une platine 120. Ces quatre échangeurs comprennent chacun une unité 102 d'échange thermique avec des composants électroniques 103 qui peuvent ne pas tous avoir les mêmes dimensions ou la même forme. Les unités 102 sont formées par des plaques 104 dont la face 104a destinés à recevoir les composants 103 est visible à travers une ouverture 120a de la platine 120. Des tubes 105 d'évaporation/condensation d'un liquide caloporteur sont disposés dans des gorges ou zones de réception façonnées dans les plaques 104, puis coudés de sorte qu'ils s'étendent dans une direction globalement perpendiculaire aux surfaces 104a sur la plus grande partie de leur longueur où ils sont entourés d'ailettes de refroidissement 106. Les plaques 104 sont pourvues, sur leurs bords 104b disposés sensiblement horizontalement à la figure 9, de feuillures non représentées qui permettent de les assembler rigidement, dans un plan, grâce à des vis de fixation 108 représentées par leurs traits d'axe.

Les bords horizontaux de l'ouverture 120a de la platine 120 peuvent être équipés de feuillures équivalentes à celles des bords des plaques 104, de sorte que les feuillures supérieures des plaques 104 supérieures et les feuillures inférieures des plaques inférieures peuvent également être utilisées pour fixer les plaques sur la platine 120.

Quel que soit le mode de réalisation considéré, les tubes 5, 55 ou 105 portent dans leur partie supérieure ou extérieure des ailettes 6, 106 ou équivalent dont la largeur est choisie sensiblement égale à celle de la plaque 4, 54, 54' ou 104 de façon à éviter toute interférence entre les ailettes de deux échangeurs disposés côte à côte et de permettre, éventuellement, leur accrochage. Avantageusement, des plaques d'étanchéité, peuvent être disposées entre les ailettes et l'unité 2, 52 ou 102 d'une part et au-dessus des ailettes d'autre part, ces plaques ayant une largeur sensiblement équivalente à celle des unités 2, 52 ou 102 et pouvant être assemblées entre elles de façon étanche.

L'invention a été représentée avec des échangeurs de chaleur di-phasiques mais elle est applicable avec des échangeurs monophasiques dans lesquels les tubes d'échange thermique renferment un fluide présent sous la même phase du côté "chaud" et du côté "froid" de chaque tube.

L'invention présentée avec des gorges est applicable avec des perçages dans lesquels sont insérés les extrémités inférieures des tubes qui y sont scellés par brasure à l'étain-plomb.

## Revendications

1. Echangeur de chaleur di-phasique ou monophasique (1) pour au moins un composant électronique de puissance (3), ledit échangeur comprenant une unité (2 ; 52 ; 102) d'échange thermique avec ledit composant et plusieurs tubes (5 ; 55 ; 105) d'échange avec un fluide caloporteur, lesdits tubes étant raccordés à ladite unité d'échange thermique formée d'au moins une plaque (4 ; 54, 54' ; 104) rigide pourvue de zones (7 ; 57, 57') de réception de parties desdits tubes caractérisé en ce que ladite unité d'échange thermique est pourvue, au niveau de deux bords (4c, 4d ; 54a, 54'a ; 104b) de moyens (4e, 4f, 4g, 4h, 8 ; 54e, 54f, 58 ; 108) d'assemblage bord à bord avec une plaque analogue (4', 4") appartenant à un échangeur voisin (1', 1") dans un groupe d'échangeurs de chaleur, lesdites plaques assemblées étant globalement coplanaires.

2. Echangeur de chaleur selon la revendication 1, caractérisé en ce que ladite plaque porte, sur un premier bord (4c), une première feuillure (4e) et, sur un second bord (4d) sensiblement parallèle audit premier bord, une seconde feuillure (4f), lesdites première et seconde feuillures étant disposées en opposition, une bordure (4g) d'une feuillure (4f) s'étendant dans l'alignement d'une première face principale (4a) de ladite plaque alors qu'une bordure de l'autre feuillure (4e) s'étend dans l'alignement d'une seconde face principale (4b) de ladite plaque (4).

3. Echangeur de chaleur selon la revendication 1, caractérisé en ce que ladite unité d'échange thermique (52) est formée de deux plaques accolées (54, 54') pourvues de gorges (57) disposées en regard et définissant des zones (59) de réception desdites parties desdits tubes (55) formant évaporateurs, lesdites plaques étant en débordement l'une par rapport à l'autre sur deux bords opposés (54a, 54'a) et sensiblement parallèles de ladite unité d'échange thermique.

4. Echangeur de chaleur selon la revendication 3, caractérisé en ce que les parties (54a, 54'a) desdites plaques (54, 54') qui débordent de la plaque en regard forment les bordures de deux feuillures (54e, 54f) disposées en opposition sur lesdits deux bords.

5. Echangeur de chaleur selon la revendication 2 ou 4, caractérisé en ce qu'il comprend des moyens (4i, 4j, 8 ; 54i, 54j, 58) de blocage d'une première feuillure (4e, 4f ; 54e, 54f) d'une première unité (2 ; 52 ; 102) appartenant à un premier échangeur (1) en position emboîtée par rapport à une seconde feuillure d'une seconde unité appartenant à un second échangeur (1', 1").

6. Echangeur de chaleur selon la revendication 5, caractérisé en ce qu'une bordure (4g ; 54'a) d'une feuillure (4f ; 54f) comprend des orifices (4i, 54i) de passage de la tige de vis de blocage (8 ; 88) et en ce qu'une bordure (4h ; 54a) de l'autre feuillure (4e ; 54e) comprend des taraudages (4j ; 54j) de réception de l'extrémité filetée desdites vis.

7. Echangeur de chaleur selon l'une des revendications précédentes, caractérisé en ce que ladite plaque (4 ; 54, 54' 104) porte, sur une au moins de ses faces principales (4a ; 54a ; 104a), des moyens (10) de fixation de composants électroniques de puissance (3 ; 53 ; 103) de formes variées et en nombre variable.

8. Echangeur de chaleur selon la revendication 7, caractérisé en ce que lesdits moyens de fixation sont des taraudages (10) répartis sur l'une au moins desdites faces (4a, 54b ; 104a).
